(19) Europäisches Patentamt
European Patent Office
Office européen des brevets

(11) **EP 2 415 089 B1**

(12) **EUROPEAN PATENT SPECIFICATION**

(45) Date of publication and mention
of the grant of the patent:
**10.07.2013 Bulletin 2013/28**

(21) Application number: **10711682.4**

(22) Date of filing: **30.03.2010**

(51) Int Cl.:
**H01L 35/32** *(2006.01)*

(86) International application number:
**PCT/EP2010/054199**

(87) International publication number:
**WO 2010/115776 (14.10.2010 Gazette 2010/41)**

(54) **THERMOELECTRIC MATERIAL COATED WITH A PROTECTIVE LAYER**

MIT EINER SCHUTZSCHICHT BESCHICHTETES THERMOELEKTRISCHES MATERIAL

MATÉRIAU THERMOÉLECTRIQUE RECOUVERT D'UNE COUCHE DE PROTECTION

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **02.04.2009 EP 09157158**
**03.06.2009 EP 09161747**

(43) Date of publication of application:
**08.02.2012 Bulletin 2012/06**

(73) Proprietor: **BASF SE**
**67056 Ludwigshafen (DE)**

(72) Inventors:
• **STEFAN, Madalina, Andreea**
**67063 Ludwigshafen (DE)**
• **SCHIERLE-ARNDT, Kerstin**
**64673 Zwingenberg (DE)**
• **HUBER, Günther**
**67071 Ludwigshafen (DE)**
• **BLACKBURN, John, Stuart**
**Widnes Cheshire WA8 5AH (GB)**
• **JONES, Ivor, Wynn**
**Chester Cheshire CH4 8AR (GB)**
• **STACKPOOL, Francis**
**Runcorn Cheshire WA7 4JQ (GB)**
• **HEAVENS, Stephen**
**Ludlow Shropshire SY8 1EE (GB)**

(56) References cited:
**US-A- 3 737 345 US-A- 3 833 387**

## Description

The present invention relates to a thermoelectric material which is coated with a protective layer to prevent degradation by humidity, oxygen, chemicals or heat as well as a thermoelectric module comprising the thermoelectric material, as well as a process for preparing the thermoelectric material and module.

Thermoelectric generators and Peltier arrangements as such have been known for some time p- and n-doped semiconductors which are heated on one side and cooled on the other side transport electrical charges through an external circuit, and electrical work can be performed by a load in the circuit. The efficiency of conversion of heat to electrical energy achieved in this process is limited thermodynamically by the Carnot efficiency. Thus, at a temperature of 1000 K on the hot side and 400 K on the "cold" side, an efficiency of (1000 - 400) : 1000 = 60% would be possible. However, only efficiencies of up to 6% have been achieved to date.

On the other hand, when a direct current is applied to such an arrangement, heat is transported from one side to the other side. Such a Peltier arrangement works as a heat pump and is therefore suitable for cooling apparatus parts, vehicles or buildings. Heating via the Peltier principle is also more favourable than conventional heating, because more heat is always transported than corresponds to the energy equivalent supplied.

A good review of effects and materials is given, for example, by George S. Nolas, Joe Poon, and Mercouri Kanatzidis.,Recent Developments in Bulk Thermoelectric Materials, MRS Bulletin, Vol 31, 2006 , 199-206.

At present, thermoelectric generators are used, for example, in space probes for generating direct currents, for cathodic corrosion protection of pipelines, for energy supply to light buoys and radio buoys and for operating radios and television sets. The advantages of thermoelectric generators lie in their extreme reliability. For instance, they work irrespective of atmospheric conditions such as atmospheric moisture; there is no fault-prone mass transfer, but rather only charge transfer. It is possible to use any fuels from hydrogen through natural gas, gasoline, kerosene, diesel fuel up to biologically obtained fuels such as rapeseed oil methyl ester.

Thermoelectric energy conversion thus fits extremely flexibly into future requirements such as hydrogen economy or energy generation from renewable energies.

A particularly attractive application is the use for converting (waste) heat to electrical energy in motor vehicles, heating systems or power plants. Thermal energy unutilized to date can even now be recovered at least partly by thermoelectric generators, but existing technologies achieve efficiencies of significantly below 10%, and so a large part of the energy is still lost unutilized. In the utilization of waste heat, there is therefore also a drive toward significantly higher efficiencies.

The conversion of solar energy directly to electrical energy would also be very attractive. Concentrators such as parabolic troughs can concentrate solar energy into thermoelectric generators, which generates electrical energy.

However, higher efficiencies are also needed for use as a heat pump.

Thermoelectrically active materials are rated essentially with reference to their efficiency. A characteristic of thermoelectric materials in this regard is what is known as the Z factor (figure of merit):

$$Z = \frac{S^2 \cdot \sigma}{\kappa}$$

with the Seebeck coefficient S, the electrical conductivity $\sigma$ and the thermal conductivity $\kappa$. Preference is given to thermoelectric materials which have a very low thermal conductivity, a very high electrical conductivity and a very large Seebeck coefficient, such that the figure of merit assumes a maximum value.

The product $S^2 \cdot \sigma$ is referred to as the power factor and serves for comparison of the thermoelectric materials.

In addition, the dimensionless product $Z \cdot T$ is often also reported for comparative purposes. Thermoelectric materials known hitherto have maximum values of $Z \cdot T$ of about 1 at an optimal temperature. Beyond this optimal temperature, the values of $Z \cdot T$ are often significantly lower than 1.

A more precise analysis shows that the efficiency (is calculated from

$$\eta = \frac{T_{high} - T_{low}}{T_{high}} \frac{M - 1}{M + \frac{T_{low}}{T_{high}}}$$

where

$$M = \left[ 1 + \frac{Z}{2} \left( T_{high} + T_{low} \right) \right]^{\frac{1}{2}}$$

(see also Mat. Sci. and Eng. B29 (1995) 228).

The aim is thus to provide a thermoelectric material having a maximum value of Z and a high realizable temperature difference. From the point of view of solid state physics, many problems have to be overcome here:

A high $\sigma$ requires a high electron mobility in the material, i.e. electrons (or holes in p-conducting materials) must not be bound strongly to the atomic cores. Materials having high electrical conductivity σ usually also have a high thermal conductivity (Wiedemann - Franz law), which does not allow Z to be favourabiy infiuenced. Materials used at present, such as $Bi_2Te_3$, already constitute compromises. For instance, the electrical conductivity is lowered to a lesser extent by alloying than the thermal conductivity. Preference is therefore given to using alloys, for example $(Bi_2Te_3)_{90}(Sb_2Te_3)_5(Sb_2Se_3)_5$ or $Bi_{12}Sb_{23}Te_{65}$.

For thermoelectric materials having high efficiency, still further boundary conditions preferably have to be fulfilled. For instance, they have to be sufficiently thermally stable to be able to work under operating conditions over the course of years without significant loss of efficiency. This requires a phase which is thermally stable at high temperatures per se, a stable phase composition, and negligible diffusion of alloy constituents into the adjoining contact materials.

In a thermoelectric module the metals/semiconductor materials are joined together by electrodes (for transportation of the generated current) and electrically isolated from other external parts. The electrodes are supported by an electrical insulator material which should allow for a good heat flow from a heat source to the thermoelectric material. Typically, thermoelectric modules incorporate ceramic plates, made for example of $SiO_2$, $Al_2O_3$ or AlN as supports having electrical insulating properties in order to prevent short-circuiting of the generated voltages. Crucially for a good heat flow from the heat source to the thermoelectric materials is a good thermally conductive substrate and an excellent joining of the parts for a minimal heat loss. Additionally, several applications, for example applications with mobile or vibrating parts, require also good mechanical stability of the module and its parts.

High temperatures over 400°C affect the longtime stability of thermoelectric materials. Sublimation is a degradation mechanism that rapidly diminishes the performance of thermoelectric devices and leads to contamination of one n- or p-semiconductor leg by the other, resulting in long-term degradation of the thermoelectric properties and of the module performance. Furthermore, thermoelectric materials oxidise at temperatures above 400°C, which additionally diminishes the efficiency and durability of thermoelectric devices. Thus, a system is needed that minimises oxidation, sublimation and contamination of the thermoelectric material in a thermoelectric module.

US 2006/0090475 and US 2006/0157101 relate to a system and method for suppressing sublimation using opacified aerogel in thermoelectric devices. An aerogel opacified with opacifying or reflecting constituents is used as an interlayer between thermoelectric materials in order to suppress sublimation and to provide thermal insulation in the thermoelectric modules.

We have found that the aerogels as used according to the US-references still do not offer best protection against degradation of the thermoelectric material. Sublimation was suppressed by using aerogels, however oxidation, degradation by thermal stress or humidity or chemical contamination cannot be prevented.

US 383387 shows a protective coating composition for a thermoelectric material consisting of a metal oxide dispersed in a enamel matrix.

The object of the present invention is to provide a thermoelectric material being better protected against degradation by humidity, oxygen, chemicals or heat.

The object is achieved according to the present invention by a thermoelectric material in a shape for forming part of a thermoelectric module, wherein the thermoelectric material is coated with a protective layer to prevent degradation by humidity, oxygen, chemicals or heat.

The layer thickness can be adjusted as required depending on the coating material. The thickness is chosen so that a substantial prevention of degradation by humidity, oxygen, chemicals or heat is achieved.

The protective layer can be chosen from all suitable protective layers. The protective layer contains a ceramic materail or a mix ture of a ceramic material and glass, to which metal can be admixed. Alternatively, the thermoelectric material can be coated with a layer of a metal, a metal alloy, a semi-metal, a semi-conductor, graphite, graphene, graphane, electrically conductive ceramics and combinations thereof. The layer thickness is chosen so that a minimum electrical and thermal shunt is produced. Surface oxidation of the metal coatings and formation of an oxide layer over the inner metal layer may enhance protection of the thermoelectric legs.

According to the present invention the thermoelectric material is coated with an inner layer of a metal or a metal alloy, a semimetal, a semi-conductor, graphite, graphene, electrically conductive ceramics or combinations thereof and an outer coating containing a ceramic material or a mixture of ceramic material and glass, to which metal can be admixed. The inner layer is directly contacted with the thermoelectric material, whereas the outer layer is coated on the inner layer. The purpose of the inner layer is to achieve a better adhesion of the outer layer with fewer cracks resulting from mismatch of the thermal expansion coefficients.

As an alternative metal and ceramic (or glass) can be combined to adjust the thermal expansion coefficient of the protective coating on the thermoelectric materials. For example, metal powder can be mixed with the ceramic or glass. The amount of metal in the mixture is preferably 50% or less, more preferably 20% or less.

The thermoelectric materials are thereby protected against degradation by the coating layer that has a similar expansion coefficient to that of the thermoelectric material, a low thermal conductivity and low electrical conductivity. The composition of the layer(s) is selected to obtain good adhesion and a good thermal and mechanical stability.

The invention also relates to a thermoelectric module comprising a series of p and n type semiconductors connected in series by conductive contacts, the conductive contacts being supported by a substrate of moderate to high thermal conductivity that is electrically insulated from the conductive contacts by a resistive surface layer, wherein the thermoelectric material of the p and n type semiconductors is coated with a protective layer as defined above.

The object is furthermore achieved by a process for preparing a thermoelectric material as defined above, involving the step of applying the protective coating layer to the thermoelectric material, e.g. by electrophoretic deposition, spraying, sputtering, electrochemical deposition or dip-coating. Further known thin layer deposition techniques can also be applied, as long as the layer thickness assures a sufficient protective function and induces preferably less than 5% heat shunt and less than 1% electrical shunt. It is considered that a satisfactory protection layer will assure during 5000 operation hours less than 5% sublimation loss.

The object is furthermore achieved by the use of the above thermoelectric module for use as a heat pump, for climate control of seating furniture, vehicles and buildings, in refrigerators and (laundry) driers, for simultaneous heating and cooling of streams in processes for substance separation, as a generator for utilizing heat sources or for cooling electronic components.

The object is furthermore achieved by a heat pump, cooler, refrigerator, (laundry) drier, generator for utilizing heat sources, generator for converting thermal energy to electrical energy, comprising at least one thermoelectric module as defined above. it was found that especially ceramic materials in combination with glass form dense thin electrically insulating barrier layers on thermoelectric material. The thermoelectric module according to the present invention has suitable strength properties and is stable at a continuous operational temperature up to 600°C.

Preferably, the protective layer is formed by a coating of a ceramic material or a glass solder, or a mixture of glass and ceramic material. The ceramic material can be chosen from a wide variety of ceramic materials which have good insulating properties. Preferably, the ceramic material comprises alumina, zirconia, titania, silica, oxides of boron, strontium, barium, phosphorus, lead, tellurium, germanium, selen, antimony, vanadium, hafnium, tantal, zinc, lanthan, yttrium, magnesium, calcium or mixtures thereof. The ceramic material may be employed as a mixture with glass, having a ratio of from 5 to 95% by weight of ceramic material to 95 to 5% by weight of glass, preferably 10 to 90% by weight of ceramic material and 90 to 10% by weight of glass, specifically 20 to 80% by weight of ceramic material and 80 to 20% by weight of glass. Furthermore, it was found that aerogels can be also successfully used as additives in the formulation applied as protective layer.

The protective layer may also be or comprise a metal or a metal alloy, a semimetal, a semiconductor, graphite, electrically conductive ceramics or combinations thereof, preferably a metal or a metal alloy. Preferably, the metal is selected from the group consisting of Ni, Mo, W, Fe, Au Fe, Ti, Pd, Al, Ag, Si or alloys thereof.

According to the present invention, an inner layer of a metal, or a metal alloy, a semi-metal, a semi-conductor, graphite, graphene, graphane, electrically conductive ceramics or combinations thereof is combined with an outer coating of a ceramic material or a mixture of ceramic material and glass. The outer layer can be also produced by partial oxidation of the inner layer (e. g. a coating of the thermoelectric material by aluminium followed by partial oxidation leading to a dense aluminium oxide protective layer).

The thickness of the protective layer is preferably in the range of from 10 nm to 500 $\mu$m.

For a ceramic or ceramic glass the coating layer thickness is preferably 1 to 50 $\mu$m. For a metal coating, the layer thickness is preferably 100 nm to 10 $\mu$m, more preferably 500 nm to 1 $\mu$m.

The ceramic glass preferably employed according to the present invention can be prepared from glass with ceramic additives like oxides of Al, Si and/or Pb. The glass gives a uniform coating, and the incorporated ceramic particles enable a thermal expansion without the formation of cracks. Because of the low thermal conductivity of glass (1 W/mK) compared to ceramics (e.g. 30 W/mK for alumina) a high proportion of glass is desirable to minimise the heat shunt. The ceramics are added to improve the expansion coefficient of the glass, especially to minimise the mechanical stress between the glass coating and the thermoelectric material due to different expansion coefficients. Preferably, the ceramic glass coating has very low or no content of oxides of alkali metals. This is advantageous since for example PbTe-thermoelectric materials can be doped with Na to obtain a p-type semi-conductor. Consequently, coatings of PbTe legs with ceramics containing alkali metal ceramics like $Na_2O$ result in a PbTe contamination with Na which degrades thermoelectric properties. Thus, according to the present invention, the protective layer is preferably free of alkali metals.

The metal or metal alloy coating of the thermoelectric material according to one aspect of the invention can be prepared by usual thin layer deposition methods. Examples of such methods are electrochemical deposition, sputtering, MBE, PVD, CVD, chemical deposition, dip-coating and sintering, pressing and/or etching/cutting, dip-coating, spin-coating, rolling of thin-plate metal on the material etc. It is possible to form one metal layer only, however, it is furthermore possible to form several successive layers of the same or different metals. For example, a thin layer of Pt was deposited to protect the thermoelectric material legs, followed by a Ni-layer which adheres better to Pt than to PbTe materials.

The metal layer can cover the complete surface of a thermoelectric leg, or only the part of the leg which is not electrically contacted by the electrodes. For a better oxidation protection the complete coating is preferred.

Instead of a metal layer, the thermoelectric material can also be coated by ceramic oxides, like TCO, ITO, AZO, ATO, FTO or doped $TiO_2$. Metals are, however, more preferred than electrically conductive ceramics.

This invention allows for a protection of the thermoelectric material by a simple application of the protective layer. Thermoelectric legs can be directly coated, or prepared rods can be first coated and then cut into thermoelectric material legs. Application of protective layers is possible on any geometrical form of the thermoelectric material legs, e.g. in cubic, plate, cylinder, ring form etc. The size of the legs can be adjusted according to the needs of the specific use of the thermoelectric module.

According to the present invention, it is possible to embed, clamp or insert the coated thermoelectric materials in a solid matrix, wherein the matrix material has a low thermal and electrical conductivity and preferably is a ceramic, glass, mica, aerogel or a combination of these materials. The matrix offers module stability, an easier module manufacture and additionally protects the thermoelectric system (materials and contacts) from degradation and contamination due to external factors like humidity, oxygen or chemicals.

This matrix can be clamped or inserted between two electrically isolated (metal) substrates (according to the invention disclosed in the European patent application 09 157 158.8) to form the complete thermoelectric module. The electrodes can be applied either on the isolated substrate or on the thermoelectric materials. The matrix consists of a material or material mixture with low thermal conductivity, so that the heat flows through the thermoelectric material and not through the matrix. While the above materials are preferred, any non-conductive material with low thermal conductivity may be employed.

As the thermoelectric material, all thermoelectric materials may be employed according to the present invention. Typical thermoelectric materials are e.g. disclosed in US 5,448,109, WO 2007/104601, WO 2007/104603.

The thermoelectric material is preferably a semiconductor, a metal, a metal alloy, a semimetal, or combinations thereof. Semiconductors are preferred: skutterudites, clathrates, Half-Heusler intermetallic alloys, Zintl phases, zinc antimonides, chalcogenides, silicon germanium and lead telluride based materials.

The semiconductor materials can be combined to form thermoelectric generators or Peltier arrangements by methods which are known per se to the person skilled in the art and are described, for example, in WO 98/44562, US 5,448,109, EP-A-1 102 334 or US 5,439,528.

By varying the chemical composition of the thermoelectric generators or Peltier arrangements, it is possible to provide different systems which satisfy different requirements in a multitude of possible applications. The inventive thermoelectric generators or Peltier arrangements thus widen the range of application of these systems.

The present invention also relates to the use of an inventive thermoelectric module

- as a heat pump
- for climate control of seating furniture, vehicles and buildings
- in refrigerators and (laundry) driers
- for simultaneous heating and cooling of streams in processes for substance separation such as

  - absorption
  - drying
  - crystallization
  - evaporation
  - distillation

- as a generator for utilization of heat sources such as

  - solar energy
  - geothermal heat
  - heat of combustion of fossil fuels
  - waste heat sources in vehicles and stationary units
  - heat sinks in the evaporation of liquid substances
  - biological heat sources

- for cooling electronic components.
- as a generator for converting thermal energy to electrical energy, for example in motor vehicles, heating systems or power plants

The present invention further relates to a heat pump, to a cooler, to a refrigerator, to a (laundry) drier, to a generator for converting thermal energy to electrical energy or to a generator for utilizing heat sources, comprising at least one inventive thermoelectric module.

The present invention is illustrated in detail with reference to the examples described below.

**Examples**

(a) Ceramic coatings

The powder materials were an yttria partially-stabilized zirconium oxide from MEL Chemicals, and aluminium oxide from Sumitomo Chemical Company. Suspensions of the materials in amyl alcohol were vibro-energy milled. EPD was carried out on PbTe thermoelectric material. The deposition potential was 30 V. Deposition was carried out for approximately 1 minute and the coated material was then removed from the bath and allowed to dry.

The coating thickness was determined from measurements of the deposit weight and area was approximately 5 $\mu$m.

(b) Glass-ceramic composite coatings

A composite glass-ceramic powder suspension suitable for EPD was produced by grinding the glass to a powder, mixing with the Sumitomo alumina powder and dispersing in alcohol. The glass used in this composite was an aluminoborate glass with the composition 46% $SiO_2$, 25% $B_2O_3$, 10% $Al_2O_3$, 4% $Na_2O$, 3% CaO, 6% SrO and 6% BaO. The coating was uniform, adherent, free of texture and free of porosity or microcracks. The thickness of the glass/alumina coating was 7 μm.

(c) Fired glass coating

A suspension of glass powder was produced by grinding 10 g glass to a powder and dispersing it in 20 ml water. The glass used was a lead oxide frit of approximate composition by weight 80% PbO 20% $SiO_2$. A cylindrical pellet of PbTe 10 mm diameter x 10 mm length was drip coated in the glass suspension, heated to 700°C for 2 minutes and allowed to cool rapidly. The fired coating was adherent, visually uniform with complete coverage and free of pores and defects.

**Claims**

1. A thermoelectric material in a shape for forming part of a thermoelectric module, which is coated with a protective layer to prevent degradation by humidity, oxygen, chemicals or heat, **characterised in that** the thermoelectric material is coated with an inner layer of a metal, a metal alloy, a semimetal, a semiconductor, graphite, graphene, graphane, electrically conductive ceramics or combinations thereof and an outer coating layer containing a ceramic material or a mixture of ceramic material and glass, to which metal can be admixed.

2. A thermoelectric material as claimed in claim 1, wherein the ceramic material comprises alumina, zirconia, titania, silica, oxides of boron, strontium, barium, phosphorus, lead, tellurium, germanium, selen, antimony, vanadium, hafnium, tantal, zinc, lanthan, yttrium, magnesium, calcium or mixtures thereof.

3. A thermoelectric material as claimed in claim 1 or 2, wherein the metal is selected from the group consisting of Ni, Mo, W, Fe, Au, Fe, Ti, Pd, Al, Ag, Si or alloys thereof.

4. The thermoelectric material as claimed in any of claims 1 to 3, wherein the thickness of the protective layer is in the range of from 10 nm to 500 μm.

5. A thermoelectric module comprising a series of p and n type semiconductors connected in series by conductive contacts, the conductive contacts being in contact with a substrate of moderate to high thermal conductivity that is electrically insulated from the conductive contacts by a resistive surface layer, wherein the thermoelectric material of the p and n type semiconductors is coated with a protective layer as defined in any of claims 1 to 4.

6. The thermoelectric module according to claim 5, wherein the substrate is a metal, a metal alloy, a semimetal, a semi-conductor, graphite, ceramics or combinations thereof.

7. The thermoelectric module according to claim 5 or 6, wherein the thermoelectric materials are embedded, clamped or inserted in a solid matrix, wherein the matrix material has a low thermal and electrical conductivity and preferably is a ceramic, glass, mica, aerogel or a combination of these materials.

8. A process for preparing a thermoelectric material according to any of claims 1 to 4, involving the step of applying the protective coating layer to the thermoelectric material.

9. The use of a thermoelectric module according to any of claims 5 to 7 for use as a heat pump, for climate control of seating furniture, vehicles and buildings, in refrigerators and (laundry) driers, for simultaneous heating and cooling of streams in processes for substance separation, as a generator for utilizing heat sources or for cooling electronic components.

10. A heat pump, cooler, refrigerator, (laundry) drier, generator for utilizing heat sources, generator for converting thermal energy to electrical energy, comprising at least one thermoelectric module according to any of claims 5 to 7.

**Patentansprüche**

1. Thermoelektrisches Material in einer Form zur Bildung eines Teils eines thermoelektrischen Moduls, das zur Verhinderung von Degradation durch Feuchtigkeit, Sauerstoff, Chemikalien oder Wärme mit einer Schutzschicht beschichtet ist, **dadurch gekennzeichnet, dass** das thermoelektrische Material mit einer inneren Schicht aus einem Metall, einer Metalllegierung, einem Halbmetall, einem Halbleiter, Graphit, Graphen, Graphan, elektrisch leitfähigen Keramiken oder Kombinationen davon und einer äußeren Beschichtungsschicht, die ein Keramikmaterial oder eine Mischung aus Keramikmaterial und Glas, dem bzw. der Metall beigemischt sein kann, enthält, beschichtet ist.

2. Thermoelektrisches Material nach Anspruch 1, wobei das Keramikmaterial Aluminiumoxid, Zirconiumoxid, Titanoxid, Siliciumoxid, Oxide von Bor, Strontium, Barium, Phosphor, Blei, Tellur, Germanium, Selen, Antimon, Vanadium, Hafnium, Tantal, Zink, Lanthan, Yttrium, Magnesium, Calcium oder Mischungen davon umfasst.

3. Thermoelektrisches Material nach Anspruch 1 oder 2, wobei das Metall aus der Gruppe bestehend aus Ni, Mo, W, Fe, Au, Fe, Ti, Pd, Al, Ag, Si oder Legierungen davon ausgewählt ist.

4. Thermoelektrisches Material nach einem der Ansprüche 1 bis 3, wobei die Dicke der Schutzschicht im Bereich von 10 nm bis 500 $\mu$m liegt.

5. Thermoelektrisches Modul, umfassend eine Reihe von p- und n-Halbleitern, die über leitfähige Kontakte in Reihe geschaltet sind, wobei die leitfähigen Kontakte mit einem Substrat mit mäßiger bis hoher Wärmeleitfähigkeit, das von den leitfähigen Kontakten durch eine Oberflächenwiderstandsschicht elektrisch isoliert ist, in Kontakt stehen, wobei das thermoelektrische Material der p- und n-Halbleiter mit einer Schutzschicht gemäß einem der Ansprüche 1 bis 4 beschichtet ist.

6. Thermoelektrisches Modul nach Anspruch 5, wobei es sich bei dem Substrat um ein Metall, eine Metalllegierung, ein Halbmetall, Graphit, Keramiken oder Kombinationen davon handelt.

7. Thermoelektrisches Modul nach Anspruch 5 oder 6, wobei die thermoelektrischen Materialien in eine feste Matrix eingebettet, eingeklemmt oder eingeschoben sind, wobei das Matrixmaterial eine geringe Wärmeleitfähigkeit und elektrische Leitfähigkeit aufweist und vorzugsweise eine Keramik, Glas, Glimmer, Aerogel oder eine Kombination dieser Materialien ist.

8. Verfahren zur Herstellung eines thermoelektrischen Materials nach einem der Ansprüche 1 bis 4, bei dem man die Schutzbeschichtungsschicht auf das thermoelektrische Material aufbringt.

9. Verwendung eines thermoelektrischen Moduls nach einem der Ansprüche 5 bis 7 zur Verwendung als Wärmepumpe, zur Klimatisierung von Sitzmöbeln, Fahrzeugen und Gebäuden, in Kühlschränken und (Wäsche)trocknern, zum gleichzeitigen Erwärmen und Abkühlen von Stoffströmen in Verfahren zur Stofftrennung, als Generator zur Nutzung von Wärmequellen oder zur Kühlung elektronischer Bauteile.

10. Wärmepumpe, Kühler, Kühlschrank, (Wäsche)trockner, Generator zur Nutzung von Wärmequellen, Generator zur Umwandlung von Wärmeenergie in elektrische Energie, umfassend mindestens ein thermoelektrisches Modul nach einem der Ansprüche 5 bis 7.

**Revendications**

1. Matériau thermoélectrique sous une forme permettant de constituer une partie d'un module thermoélectrique, qui est recouvert d'une couche de protection pour empêcher la dégradation par l'humidité, l'oxygène, les produits chimiques ou la chaleur, **caractérisé en ce que** le matériau thermoélectrique est recouvert d'une couche interne d'un métal, d'un alliage métallique, d'un semi-métal, d'un semi-conducteur, de graphite, de graphène, de graphane, d'une céramique électriquement conductrice ou d'une combinaison de ceux-ci, et d'une couche de revêtement externe contenant un matériau céramique ou un mélange de matériau céramique et de verre, auquel un métal peut être ajouté.

2. Matériau thermoélectrique selon la revendication 1, dans lequel le matériau céramique comprend l'alumine, la zircone, le dioxyde de titane, la silice, les oxydes de bore, le strontium, le baryum, le phosphore, le plomb, le tellure, le germanium, le sélénium, l'antimoine, le vanadium, le hafnium, le tantale, le zinc, le lanthane, l'yttrium, le magnésium, le calcium et les mélanges de ceux-ci.

3. Matériau thermoélectrique selon la revendication 1 ou 2, dans lequel le métal est choisi dans le groupe constitué par Ni, Mo, W, Fe, Au, Fe, Ti, Pd, Al, Ag, Si et les alliages de ceux-ci.

4. Matériau thermoélectrique selon l'une quelconque des revendications 1 à 3, dans lequel l'épaisseur de la couche de protection se situe dans la gamme de 10 nm à 500 $\mu$m.

5. Module thermoélectrique comprenant une série de semi-conducteurs de type p et n reliés en série par des contacts conducteurs, les contacts conducteurs étant en contact avec un substrat de conductivité thermique moyenne à élevée qui est électriquement isolé des contacts conducteurs par une couche de surface résistive, le matériau thermoélectrique des semi-conducteurs de type p et n étant recouvert d'une couche de protection telle que définie dans l'une quelconque des revendications 1 à 4.

6. Module thermoélectrique selon la revendication 5, dans lequel le substrat est un métal, un alliage métallique, un semi-métal, un semi-conducteur, du graphite, une céramique ou une combinaison de ceux-ci.

7. Module thermoélectrique selon la revendication 5 ou 6, dans lequel les matériaux thermoélectriques sont incorporés, attachés ou insérés dans une matrice solide, le matériau de la matrice ayant une faible conductivité thermique et électrique et étant de préférence une céramique, du verre, du mica, un aérogel ou une combinaison de ces matériaux.

8. Procédé de préparation d'un matériau thermoélectrique selon l'une quelconque des revendications 1 à 4, impliquant l'étape consistant à appliquer la couche de revêtement protecteur au matériau thermoélectrique.

9. Utilisation d'un module thermoélectrique selon l'une quelconque des revendications 5 à 7 pour utilisation comme une pompe à chaleur, pour la climatisation de mobilier d'assise, de véhicules et de bâtiments, dans des réfrigérateurs et des sécheurs (sèche-linge), pour le chauffage et le refroidissement simultanés de courants dans des procédés de séparation de substances, comme un générateur pour utiliser des sources de chaleur ou pour refroidir des composants électroniques.

10. Pompe à chaleur, refroidisseur, réfrigérateur, sécheur (sèche-linge), générateur pour utiliser des sources de chaleur, générateur pour convertir l'énergie thermique en énergie électrique, comprenant au moins un module thermoélectrique selon l'une quelconque des revendications 5 à 7.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20060090475 A
- US 20060157101 A
- US 383387 A
- EP 09157158 A
- US 5448109 A
- WO 2007104601 A
- WO 2007104603 A
- WO 9844562 A
- EP 1102334 A
- US 5439528 A

**Non-patent literature cited in the description**

- **GEORGE S. NOLAS ; JOE POON ; MERCOURI KANATZIDIS.** Recent Developments in Bulk Thermoelectric Materials. *MRS Bulletin,* 2006, vol. 31, 199-206
- *Mat. Sci. and Eng.,* 1995, vol. B29, 228